Europäisches Patentamt

European Patent Office

Office européen des brevets

(19)

(11) EP 1 605 592 A2

(12) **EUROPEAN PATENT APPLICATION**

(43) Date of publication:
**14.12.2005 Bulletin 2005/50**

(51) Int Cl.⁷: **H03K 17/0814**

(21) Application number: **05104411.3**

(22) Date of filing: **24.05.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **07.06.2004 IT PN20040039**

(71) Applicant: **IRCA S.p.A.**
**31010 San Vendemiano, Treviso (IT)**

(72) Inventors:
- **PLOS, Livio**
  **33170, PORDENONE (IT)**
- **TAURIAN, Andrea**
  **33080, PORCIA (PN) (IT)**
- **MARINO, Daniele**
  **31015, CONEGLIANO (TV) (IT)**

(74) Representative: **Giugni, Valter et al**
**PROPRIA S.r.l.,**
**Via Mazzini 13**
**33170 Pordenone (IT)**

(54) **Improvement in a TRIAC protection circuit**

(57) Means for controlling the alternating current flowing to and across a load (R), comprising:

- a connection connecting a polarity of the power supply line to said load,
- a circuit connected in series with said connection and comprising two branches arranged in parallel to each other, in which an alternating-current control and switching device (3), such as a TRIAC or a SCR, is connected in series in the first branch, and a relay (4) is connected in series in the second branch.

In said first circuit branch there is arranged a cutout device (7) that is adapted to cut off the current when the average value of said current in said first branch is greater, in a pre-determined time interval, than a pre-set value. Said current cutout device is a time-delay fuse.

Fig. 3

EP 1 605 592 A2

**Description**

The present invention relates to a specific circuit arrangement adapted to protect a current regulation device, such as in particular a TRIAC, in a circuit provided to control the alternating current being supplied to various loads, in particular resistive loads.

Largely used among the most common current switching devices is certainly the relay, owing mainly to the well-known characteristics of substantial simplicity thereof, as well as owing to the peculiarity thereof of being substantially a controlled electromechanical switch, so that, when either an alternating current or a direct current is flowing therethrough, the amount of power absorbed at the contact point is negligible.

However, when a relay is due to perform as an alternating-current control and switching device, and when the current to be controlled and switched is rather sizeable, such as for instance in the case of residential space-heating resistive loads supplied with line voltage, following problem arises and must be duly coped with: if the interruption, i.e. switching occurs when the current on the relay is still at a significant value thereof, then - owing to largely known reasons - the well-known flashing or sparking effect takes place on the contacts of the relay.

Such effect - although not inherently dangerous - is however not acceptable or shall anyway be reduced to a minimum, especially in residential applications and home appliances in general, owing to international safety standards requiring that said flashing or sparking be kept at very low levels in electric appliances and equipment.

In order to do away with such undesired effect, known in the art is the practice based on connecting in parallel to said relay an appropriate controlled current-switching device, typically a TRIAC, which has operating characteristics that are completely different from and - to a certain extent - complementary to those of the relay.

The present invention equally applies to other semiconductor devices adapted to perform as current-control arrangements, such as for instance silicon controlled rectifiers and similar devices. For reasons of greater simplicity, the following description will however solely - and by way of non-limiting example - refer to TRIAC-type devices.

If a TRIAC is driven to only close the circuit (in the respective branch thereof) in the very short time intervals during which the relay is operated in both the make and break functions thereof, it then ensues that the totality of the current is bypassed, or shortcircuited, into the branch containing the TRIAC when the relay is operated; as a result, the relay can therefore be operated safely, since, owing to no current flowing therethrough, it cannot give rise to any flashing or sparking.

Immediately upon the relay having so been operated, the TRIAC is opened again and the current starts to flow again through the relay, however without giving rise to any sparking.

The time interval during which the TRIAC stays in a closed state is very short, so that no cooling arrangement or device is generally provided for the same TRIAC.

The above-described mode of operation is preferably used in all those cases in which the alternating current passes through zero, since it is in this moment that even the operation of the TRIAC is in particular optimised. This mode of operation can on the other hand by implemented in a quite easy manner, since the TRIAC cab be driven in a throughout accurate manner, as compared with the far less accuracy in controlling the relay.

However, even the - albeit rather unimportant from an operative point of view - possibility can be considered for the TRIAC to be triggered to close at moments when the current is not zero, but has on the contrary a significant value.

Although seemingly safe in itself, the above-described mode of operation is however not free of risks. As a matter of fact:

- should the TRIAC for any reason whatsoever - even a trifling one - fail to be triggered just for the very short time interval required to also operate the relay, and stays on the contrary closed for even a slightly longer time, without the relay being closed in turn,

- and since the totality of the current being supplied to the load flows therethough, with the relay still in its opened state,

- or should a failure or a short-circuit condition occur inside the TRIAC,

the result - as all those skilled in the art are well aware of - is in all cases that the TRIAC itself is immediately subject to a considerable overheating effect.

On the other hand, as already mentioned hereinbefore, the TRIAC is not arranged on any particular heat-sink means in this particular kind of applications, since it actually remains only active for a very short period of time in normal operation. Furthermore, the TRIAC is appropriately selected on the basis of its particular characteristics and ratings in view of a throughout specific mode of use, in which it is required to close for a very short period of time (i.e. until the parallel-connected relay is operated). As a result, it can be readily appreciated that, in the case that the TRIAC is caused or happens to stay closed for a significant period of time, eg. even a few minutes, it immediately overheats to a temperature that may be as excessively high as to cause it to flare up, i.e. burn. The consequences of this are readily apparent, as further aggravated by the circumstance that in a residential, i.e. household environment there are generally provided neither safety systems nor utilization modes that might be such as to remedy or make up for a serious prejudicial occurrence like this.

This situation is not even considered as a hypothesis, i.e. is plainly neglected by the applying safety standard regulations, and this most obviously makes the above-cited drawback still more insidious and, therefore, dangerous.

It would therefore be desirable, and it is actually a main object of the present invention to provide a kind of electric circuit that is inherently capable of doing away with the afore-cited safety-related problem arising when a current-control means (TRIAC, SCR, or the like), associated to a relay in a parallel arrangement thereto, is unduly switched into a conducting state, i.e. caused to conduct for a time interval that is longer than a pre-set longest allowable time, wherein this electric circuit shall furthermore be capable of being manufactured in a low-cost, simple manner using readily available materials and techniques.

According to the present invention, these aims, along with further ones that will become apparent in the course of the following description, are reached in a kind of electric circuit that is made and operates according to and with the characteristics as recited in the appended claims.

The present invention may be implemented in the form of a preferred, although not sole embodiment that will be described in greater detail and illustrated below by mere way of non-limiting example with reference to the accompanying drawings, in which:

- Figure 1 is a view of a protection device according to the present invention in a general embodiment thereof;

- Figure 2 is a diagrammatical view of the characteristic curves of a number of fuses generally available on the market, which may be used in conjunction with the present invention;

- Figure 3 is a view of an improved embodiment of the circuit shown in Figure 1, according to the present invention.

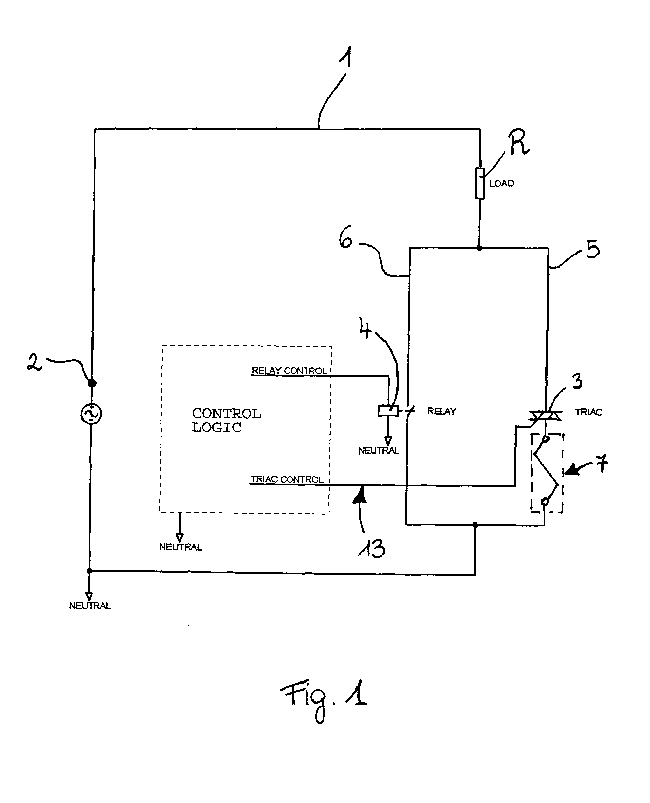

With reference to Figure 1, a protection circuit according to the present invention comprises:

- a load R
- a connection 1 connecting a polarity 2 of the power supply line to said load R,
- a circuit connected in series with said connection 1 and comprising two branches 5, 6 arranged in parallel to each other, in which
- a TRIAC 3 is connected in series in the first branch 5, and
- a relay 4 is connected in series in the second branch 6.

According to the present invention, in said first circuit branch 5 there is arranged a device 7 adapted to cut off the current; this device 7 is so selected and provided as to be adapted to automatically cut out the current flowing thereacross when, in a pre-determined time interval, the average value of said current is greater than a pre-set value.

Basically, this device 7, which operates as an on/off current switch, is a device that can be made and provided in various forms and manners generally known as such in the art; however, the present invention is not based on the fact of having such current cut-out device provided to safety purposes in said first branch 5 of the circuit, since such devices and the function thereof are widely known as such in the art.

The present invention is rather based on the fact of providing said device as a safety provision relative to the average value of the current flowing across the TRIAC during a determined period of time.

It should in fact be noticed that the actual purpose is not determining the maximum, i.e. highest value of the current across the TRIAC, but rather the fact that such highest current, which is on the other hand limited by the load R, does not persist beyond a pre-determined short period of time. As noted hereinbefore, in fact, what has to be actually prevented with this provision is the possibility for the TRIAC to undergo an excessive overheating, wherein such overheating is obviously the result of dissipated energy, i.e. the power that is dissipated by the TRIAC itself in a given time interval.

This dissipated power is in turn the result of the current flowing thereacross by the resistance of the TRIAC; owing however to the fact that the current across the TRIAC is not in charge of, i.e. does not depend on the same TRIAC, but is rather commanded by the afore-cited load R, and since the resistance r of the TRIAC in the conducting state thereof is a function of the same current, i.e.

$$R = r(I)$$

it ensues (by simplifying) that

$$P = V.I = I^2 . r(I)$$

so that, when multiplying by the time t, it therefore ensues:

$$P.t = V.I = I^2 . r . t$$

As a result, since the resistance r of the TRIAC is an inherent, peculiar characteristic of each single TRIAC, on which it is therefore not possible to act (owing to such devices involving silicon junctions, actually), and the current cannot be modified, it ensues that, if the energy dissipated on the TRIAC, i.e. P.t, is to be limited for a determined period of time, the sole parameter which can be acted upon, i.e. which can be affected to such purpose, is the time t.

This therefore fully explains why said device 7 is due to cut out the current in the circuit 5 as soon as it is found persisting beyond a pre-determined interval.

A variety of circuit arrangements - all of which are generally known as such in the art, and which may even be quite complex - can be used to such purpose. However, the simplest and most reliable current cut-out device that can be considered for use in this case is the fuse, provided of course that its characteristics are consistent with the particular function it is asked to perform.

The selected fuse shall in fact not break the circuit upon just a highest allowable current having been reached instantaneously, but shall rather break when a pre-defined current flows therethrough for a pre-defined period of time, i.e. when it dissipates a pre-defined largest allowable amount of energy in a pre-defined period of time.

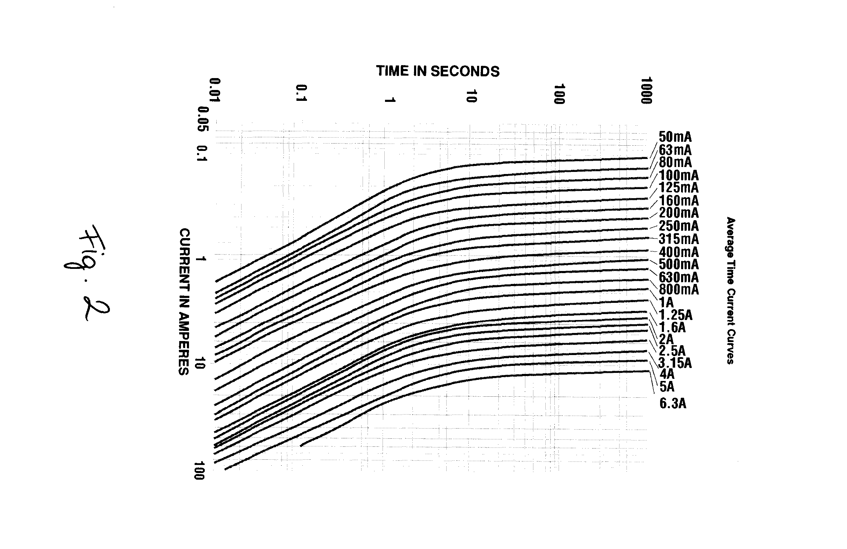

In this connection, reference should now be made to Figure 2, which illustrates a typical example of the operating/breaking or tripping curves of market-type fuses, in which each single curve obviously represents a particular tripping setting of a respective fuse, as compared with the plurality of fuses that have the respective curves represented and identified.

Thus, once the maximum tripping time, which is plotted in the ordinate, and the tripping current I (calculated separately and plotted in the abscissa) have been identified, these values will univocally identify a point in the diagram of Figure 2, which in turn identifies the type of fuse to be selected.

It will most obviously be necessary for further refinements and experimental results to be brought in and used in view of optimising the above-indicated selection process. Anyway, this kind of information and further refinements are fully within the abilities of those skilled in the art, so that they shall not be dealt with here to any greater extent.

In particular, preferred will be in this case the so-called time-delay fuses, i.e. fuses that have the basic feature of including a certain thermal mass so that they are capable of only breaking the circuit after a certain time has elapsed from the beginning of the tripping, i.e. burn-out current, i.e. take a longer time to reach their tripping or burnout temperature.

When taking a closer look at the circuit illustrated schematically in Figure 1, it can be noticed that it anyway involves a possible problem. As a matter of fact, if the fuse 7 breaks, i.e. opens its respective circuit, then the conductor 10 on the TRIAC remains "hanging" by, i. e. remains "attached" to the polarity 2, which is connected to the phase of the power supply line. It may therefore occur - and this would by no means be a rare event - that such phase gets inadvertently connected with the TRIAC driving circuit 13, with the almost certain result that this TRIAC driving circuit is automatically destroyed.

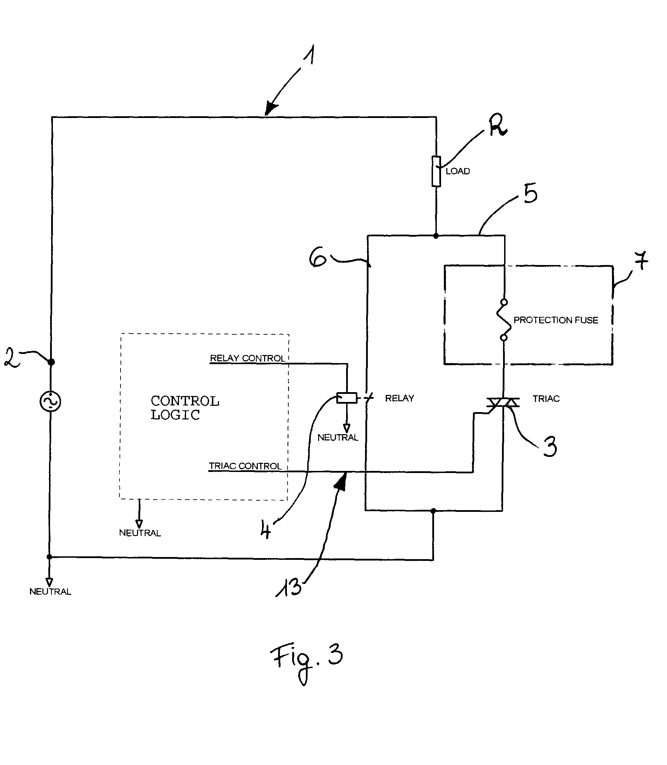

In view of doing away with such kind of problem, and with reference to Figure 3, said fuse member 7 is arranged between the TRIAC and the polarity 2 of the line phase, so that, in the event of a burnout of the fuse 7, this will leave the TRIAC interrupted, i.e. separated also from said polarity 2 connected to the power-supply line phase, thereby doing inherently away with any possibility for a terminal thereof to become connected to the same line phase.

**Claims**

1. Means for controlling the alternating current that flows to a load (R), comprising:

   - a connection (1) connecting a polarity (2) of the power supply line to said load (R),
   - a circuit connected in series with said connection (1) and comprising two branches (5, 6) arranged in parallel to each other, in which an alternating-current control and switching device (3), such as a TRIAC or a SCR, is connected in series in the first branch (5), and a relay (4) is connected in series in the second branch (6), **characterized in that** in said first circuit branch (5) there is arranged a cutout device (7) that is adapted to cut off the current when the average value of said current in said first branch (5) is greater, in a pre-determined time interval, than a pre-set value.

2. Current control means according to claim 1, **characterized in that** said current cutout device is a fuse.

3. Current control means according to claim 2, **characterized in that** said fuse is a time-delay fuse.

4. Current control means according to any of the preceding claims, **characterized in that** said current cutout device (7) is arranged between said TRIAC and said phase pole (2) of said power supply line.

Fig. 1

Average Time Current Curves

Fig. 2

Fig. 3